Europäisches Patentamt

(19) European Patent Office    (11) Publication number:    **0 217 827**
Office européen des brevets                            **B1**

(12) **EUROPEAN PATENT SPECIFICATION**

(45) Date of publication of the patent specification:    (51) Int. Cl.⁴: **H 01 R 13/518**
12.07.89

(21) Application number: **86901684.0**

(22) Date of filling: **24.02.86**

(86) International application number:
**PCT/US 86/00377**

(87) International publication number:
**WO 86/05329 (12.09.86 Gazette 86/20)**

(54) **MULTIPLE CONNECTOR ASSEMBLY.**

| | |
|---|---|
| (30) Priority: **05.03.85 US 708460** | (73) Proprietor: **NCR Corporation, World Headquarters, Dayton, Ohio 45479 (US)** |
| (43) Date of publication of application: **15.04.87 Bulletin 87/16** | (72) Inventor: **PORTER, Warren, Wesley, 1821 Castle Glen, Escondido, CA 92025 (US)** Inventor: **THIES, Louis, William, 5431 Westknoll Drive, La Jolla, CA 92037 (US)** |
| (45) Publication of the grant of the patent: **12.07.89 Bulletin 89/28** | |
| (84) Designated Contracting States: **DE FR GB** | (74) Representative: **Robinson, Robert George, International Patent Department NCR Limited 206 Marylebone Road, London NW1 6LY (GB)** |
| (56) References cited: **AU-D-1 550 770 DE-A-2 919 758 FR-A-2 118 415** **BBC Nachrichten, volume56, no. 3, 1974 Mannheim (DE) . F.Leger: "Platz und Montagezeit sparendes Zubehoer fuer den Verteilungsbau" pages 69-73,** | |

LIBER, STOCKHOLM 1989

## Description

## Technical Field

This invention relates to multiple connector assemblies.

## Background Art

Certain classes of electronic equipment have an expandable feature which in turn necessitates the use of additional connectors for bringing in signals and additional power. These needs can be satisfied in a variety of ways, one of which is to build the basic system with all of the possible connectors that can be used fitted onto the system at the time of manufacture. The cost associated with doing this make this a highly undesirable option. It is more desirable to have a system wherein the customer can add connectors of the particular type and quantity desired at any time and or rearrange the connectors without the need of special tools and fabrication techniques.

An additional problem arises when the back panel of the electronic equipment has to remain electrically secure from radio frequency emissions, that is when the back panel has to be a shield with no openings through which radio frequency emissions can pass. Furthermore, there is the problem that is associated with grounding in that it is advantageous from an electrical point of view to have the connector and its housing grounded to the potential of the back panel.

From U.S. Patent No. 4 131 330 there is known a mounting device for electrical connectors including electrically insulating mounting panels in which there are formed slots each adapted to house a plurality of electrical connectors. This known device provides some flexibility in that a user can insert connectors and specific wiring of his own choosing. However, the degree of reconfiguration is restricted since only connectors of a certain size can be inserted in the slots. Also, this known device does not provide shielding in respect of radio frequency emissions.

From FR-A-2 118 415 there is known an assembly of electrical devices, such as electromagnetic relays, in which each device is provided with a mounting flange which may be of metal or plastic material. The devices are mounted in an elongated aperture formed in a metal plate, and, by virtue of an interlocking arrangement of the mounting flanges, all the devices can be held in position by means of a single bar extending across the aperture, the bar being disposed on the side of the metal plate opposite the side engaged by the flanges and being secured to one of the flanges by means of a screw.

From DE-A-2 919 758 there is known a fastening arrangement for mounting a single plug connector in a panel opening, opposite short edge portions of a rectangular mounting flange of the connector being held by means of clamping bars or leaf springs against portions of the panel.

Neither FR-A-2 118 415 nor DE-A-2 919 758 is concerned with the problem of designing an assembly of electrical devices which assembly provides electrical shielding.

## Disclosure of the Invention

It is an object of the present invention to provide a multiple connector assembly which is highly versatile as regards reconfiguration of its connectors, which can be reconfigured without the use of special tools and complicated techniques, and which can provide electrical shielding.

According to the invention, there is provided a multiple connector assembly, characterized by a plurality of electrical connectors respectively provided with electrically conductive mounting flanges, a panel formed of electrically conductive material and having a plurality of elongated openings formed therein for receiving said electrical connectors, said openings extending generally parallel to each other, a plurality of elongated clamping bars extending along substantially the whole length of said elongated openings in said panel, with one clamping bar being positioned between the longitudinal axes of each adjacent pair of said openings, and fastening means for removably fastening said clamping bars to said panel so as to secure said connectors to said panel with opposite edge portions of the mounting flange of each connector being respectively held by means of two clamping bars against portions of said panel disposed on opposite sides of an elongated opening in said panel, any part of a said opening not spanned by a said mounting flange being closed by an electrically conductive blank plate opposite edge portions of which are respectively held by the relevant two clamping bars against portions of said panel disposed on opposite sides of the said opening.

## Brief Description of the Drawings

One embodiment of the invention will now be described by way of example with reference to the accompanying drawings, in which:

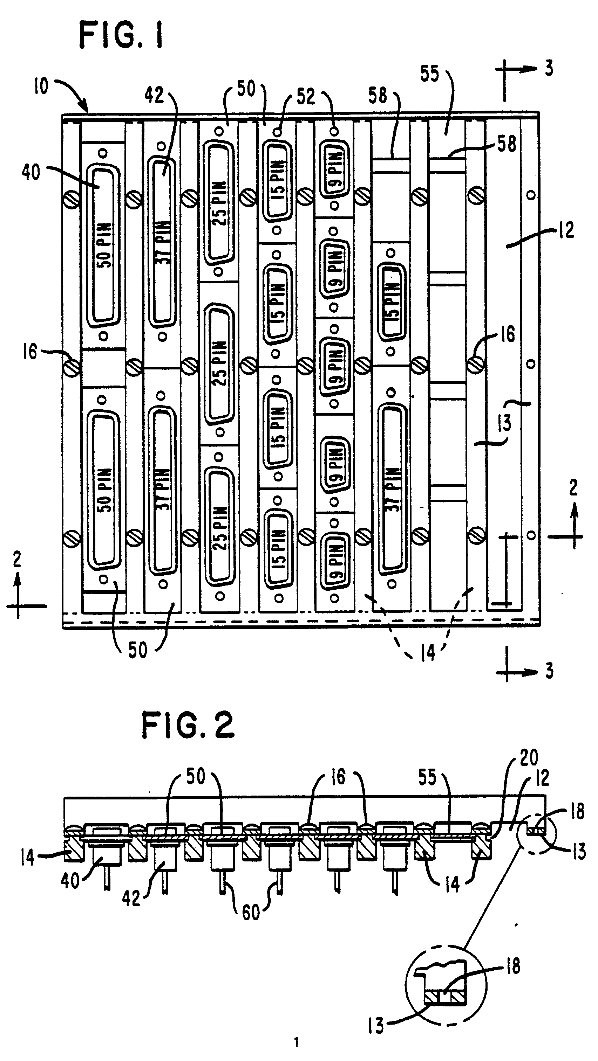

Fig. 1    is a front view of a connector panel with a variety of connectors shown fixed in place;

Ftg. 2    is a sectioned view taken along the Section lines 2 - 2 of the embodiment shown in Fig. 1;

Fig. 3    is a sectioned view of the embodiment shown in Fig. 1 taken along the section line 3 - 3;

Fig. 4    illustrates in a perspective view a clamping member used in the preferred embodiment of the invention;

Fig. 5  is an exploded view illustrating the relationship between a mounting flange and a connector of the type shown in Fig. 1;

Fig. 6  illustrates in perspective view a metallic plate which may be used as a filler in the panel shown in Fig. 1.

## Best Mode for Carrying Out the Invention

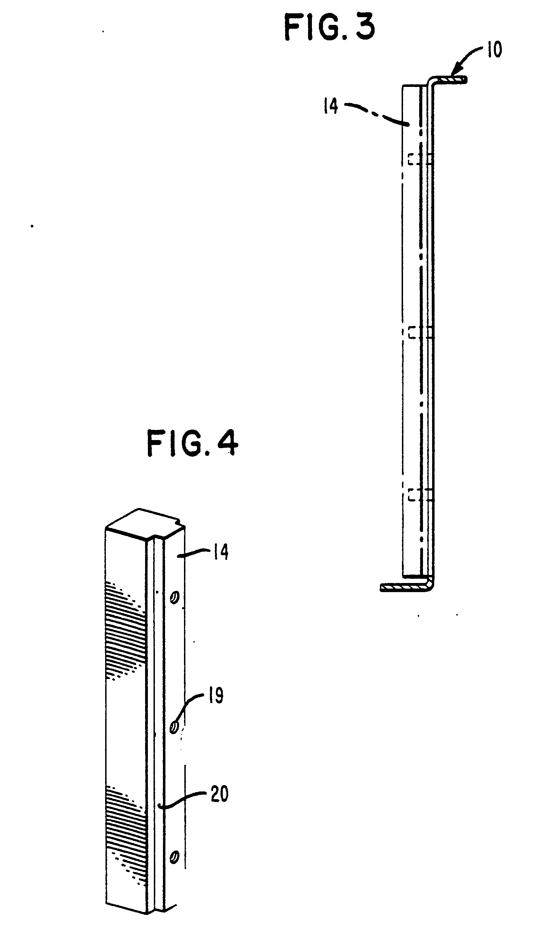

Referring to Fig. 1 in conjunction with Figs. 2 and 3, a back panel 10 of the present invention is fabricated from sheet metal having parallel elongated openings 12 defined therein. Each opening is separated from the next by a rectangular portion 13. The back panel is configured in height and width to a size which will fill the opening appearing in the back portion of an electrical equipment cabinet.

Electrical connectors 42, having differing number of pins but substantially the same physical width, are shown positioned within the openings 12 in different configurations. For example, in the fifth row from the left there is shown a 9 pin configuration wherein five such 9 pin connectors are shown positioned so as to fill the elongated opening. In a like manner four 15 pin connectors, because of their increased length, can accomplish the same filling or utilization of the space. The 25 pin connectors fill the space with only three being insertable. The 37 pin connectors permit two to be inserted into an opening 12. In the sixth row, a 37 pin connector is combined with a 15 pin connector, while in the eleventh row there is illustrated the filling of the longitudinal opening with a metal plate 55.

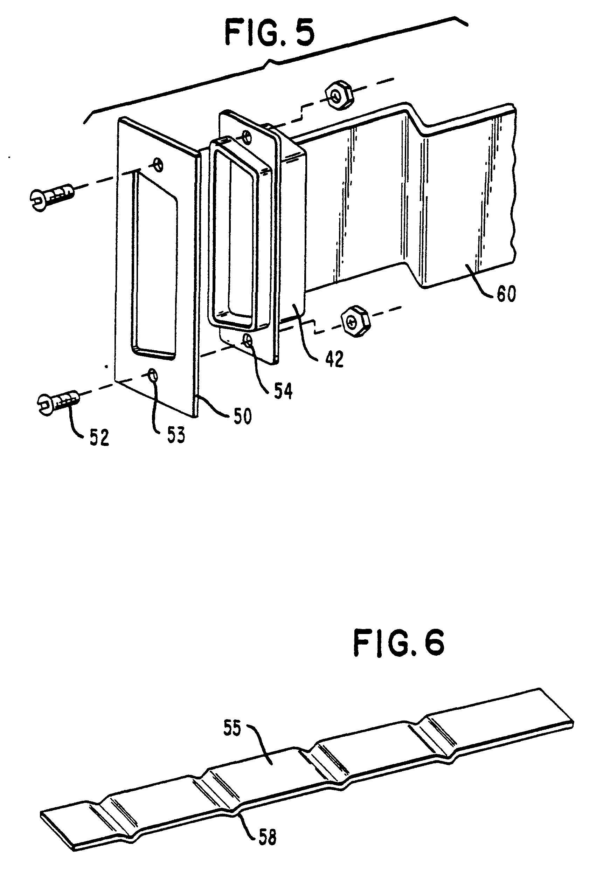

An electrically conductive mounting flange 50 (shown in Fig. 5) is provided for each of the connectors, such mounting flange being of a width slightly greater than the width of the openings 12 so that the mounting flange laps on the adjacent rectangular portions 13, preventing the connector from passing through the relevant opening 12 and providing an electrical contact between an electrically conductive housing of the connector and the back panel 10 (which in operation is electrically grounded). Clamping bars 14, having threaded holes 19 therein (shown in Fig. 4), are affixed to the rear surface of the back panel by means of fasteners such as screws 16. The clamping bars are formed from conductive material such that they form a continual conductive surface with the connector housings and the mounting flanges in conjunction with the conductive back panel. In some instances, for example with a 50 pin electrical conductor connector identified as element 40 in Fig. 1, the use of a separate connector flange 50 may not be required. In that instance, the connector may be held in place directly by the use of clamping bars 14 which clamp an electrically conductive flange formed integral with the housing of the connector. Any openings at the ends of the connectors 40 and 42 can be filled with segments of metal plate material taken from a blank filler plate 55, shown in Fig. 6.

Referring now specifically to Fig. 4, the clamping bar 14, made of conductive material, is shown having a recessed surface 20, milled from each of its opposing sides to receive a mounting flange and/or a blank metal plate 55 (shown in Fig. 6). The clamping bar receives the screws 16 that pass through the screw holes 18 in the relevant back panel rectangular portion 13 to clamp the bar to the back panel 10. The screws 16 are removable so as to enable easy removal of each clamping bar 14 from the panel 10.

Referring now to Fig. 5, a typical connector 42 having a wiring lead 60 is shown connectable to the conductive mounting flange 50, rectangular in shape, and having fastener openings 53, corresponding to openings 54 in the connector body, for receiving fasteners 52 which for example may be a bolt and nut assembly.

Fig. 6 illustrates the metallic plate 55 which is insertable into an opening 12 for electrically closing the opening. The plate has a plurality of transverse dimples 58 which give the relatively thin plate a total displacement thickness equivalent to that normally achieved by the mounting flanges 50 so as to provide a contacting thickness between the clamping bar 14 and the back panel 10 such that tightening of the clamping bar into position with the screws 16 will ensure electrical contact between the clamping bar, the dimpled plate and the back panel. Any opening 12 or part thereof not closed by the connectors 40, 42 and flanges 50 is closed by a plate 55 or by a portion cut therefrom so that total electrical shielding is provided by the panel.

Once the customer has assembled the connectors in the configuration desired, it is obvious that the configuration may be changed by adding additional connectors where desired and/or deleting connectors that are no longer needed.

From the foregoing, it can be seen that the invention permits a high degree of versatility in the configuring of a back panel wherein various sizes of connectors may be positioned without the need for specialized tools. In addition, although the disclosure has been directed to connectors of a rectangular configuration, it would be obvious that connectors having, for example, either square, round or hexagon, or any other shape can be used by adjusting the openings in the back panel and configuring the mounting flanges to fill the openings that would appear between the outlines of the connector bodies and the openings through the connector panel.

## Claims

1. A multiple connector assembly, comprising a plurality of electrical connectors (40, 42) respectively provided with electrically conductive mounting flanges (50), a panel (10) formed of electrically conductive material and having a plurality of elongated openings (12) formed therein for receiving said electrical connectors (40, 42), said openings extending generally parallel to each other, a plurality of elongated clamping bars (14) extending along substantially the whole length of said elongated openings (12) in said panel (10), with one clamping bar being positioned between the longitudinal axes of each adjacent pair of said openings, and fastening means (16) for removably fastening said clamping bars (14) to said panel (10) so as to secure said connectors (40, 42) to said panel with opposite edge portions of the mounting flange (50) of each connector being respectively held by means of two clamping bars (14) against portions of said panel (10) disposed on opposite sides of an elongated opening (12) in said panel, any part of a said opening (12) not spanned by a said mounting flange (50) being closed by an electrically conductive blank plate (55) opposite edge portions of which are respectively held by the relevant two clamping bars (14) against portions of said panel (10) disposed on opposite sides of the said opening.

2. A multiple connector panel according to claim 1, wherein each clamping bar (14) is of electrically conductive material.

3. A multiple connector panel according to either claim 1 or claim 2, wherein each of said clamping bars (14) has a width substantially equal to the spacing between adjacent elongated openings (12) in said panel (10).

4. A multiple connector assembly according to any one of the preceding claims, wherein the or each blank plate (55) is of sheet material having a thickness less than that of said flanges (50) and is provided with at least one traverse dimple (58) so as to increase the effective thickness of the blank plate to correspond to the thickness of said flanges.

5. A multiple connector assembly according to any one of the preceding claims, wherein at least some of said mounting flanges (50) are each in the form of a plate which has a central aperture in which the respective connector is inserted and which is removably fastened to the respective connector.

6. A multiple connector assembly according to any of the preceding claims, wherein each clamping bar (14) has longitudinal recessed portions (20) extending along opposite sides thereof, each recessed portion (20) being adapted to receive an edge portion of a mounting flange (50) when holding the flange against the panel (10).

**Patentansprüche**

1. Vielfachverbinderanordnung mit einer Vielzahl elektrischer Verbinder (40, 42), die entsprechend mit elektrisch leitenden Befestigungsflanschen (50) versehen sind, einer Platte (10)

aus elektrisch leitendem Material und mit einer Vielzahl länglicher Öffnungen (12), die darin zur Aufnahme der elektrischen Verbinder (40, 42) ausgebildet sind, wobei die Öffnungen sich durchwegs parallel zueinander erstrecken, einer Vielzahl von länglichen Klemmleisten (14), die sich im wesentlichen über die ganze Länge der länglichen Öffnungen (12) in der Platte (10) erstrecken, wobei eine den Längsachsen jedes benachbarten Paares der Öffnungen angeordnet ist, und Befestigungsvorrichtungen (16) zum entfernbaren Befestigen der Klemmleisten (14) an der Platte (10), um die Verbinder (40, 42) an der Platte zu befestigen, wobei gegenüberliegende Kantenteile des Befestigungsflansches (50) jedes Verbinders entsprechend durch zwei Klemmleisten (14) gegen Teile der Platte (20) gehalten werden, die an gegenüberliegenden Seiten der länglichen Öffnung (12) in der Platte verlaufen, wobei ein Teil einer Öffnung (12), der nicht von einem Befestigungsflansch (50) übergriffen ist, durch eine elektrisch leitende blanke Platte (55) geschlossen ist, deren gegenüberliegende Kantenteile entsprechend durch die zutreffenden zwei Klemmleisten (14) gegen Teile der Platte (10) gehalten werden, die auf gegenüberliegenden Seiten der Öffnung verlaufen.

2. Vielfachverbinderfeld nach Anspruch 1, wobei jede Klemmleiste 14 aus elektrisch leitendem Material ist.

3. Vielfachverbinderfeld nach Anspruch 1 oder Anspruch 2, wobei jede der Klemmleisten (14) eine Breite besitzt, die im wesentlichen gleich dem Abstand zwischen benachbarten länglichen Öffnungen (12) in der Platte (10) ist.

4. Vielfachverbinderanordnung nach einem der vorhergehenden Ansprüche, wobei die oder jede blanke Platte (55) aus Blechmaterial mit einer Dicke ist, die geringer als diejenige der Flansche (50) ist und mit zumindest einer Querdicke aufweist, um die effektive Dicke der blanken Platte derart zu erhöhen, daß sie der Dicke der Flansche entspricht.

5. Vielfachverbinderanordnung nach einem der vorhergehenden Ansprüche, wobei zumindest einige der Befestigungsflansche (50) die jeweils die Form einer Platte besitzen, die eine zentrale Öffnung aufweist, in der der entsprechende Verbinder eingesetzt ist und die entfernbar an dem entsprechenden Verbinder befestigt ist.

6. Vielfachverbinderanordnung nach einem der vorhergehenden Ansprüche, wobei jede Klemmleiste (14) Längsausnehmungsteile (20) besitzt, die sich auf deren gegenüberliegenden Seiten erstrecken, wobei jeder Längsausnehmungsteil (20) geeignet ist, einen Kantenteil eines Befestigungsflansches (50) aufzunehmen, wenn er den Flansch gegen die Platte (10) hält.

**Revendications**

1. Assemblage de connecteurs multiples, comprenant plusieurs connecteurs électriques (40, 42) équipés respectivement de brides électriquement conductrices (50) de montage, un panneau (10) formé d'une matière électriquement conductrice et dans lequel sont formées plusieurs ouvertures allongées (12) destinées à recevoir lesdits connecteurs électriques (40, 42), lesdites ouvertures s'étendant globalement parallèlement les unes aux autres, plusieurs barrettes allongées (14) de bridage s'étendant sensiblement sur toute la longueur desdites ouvertures allongées (12) dans ledit panneau (10), une barrette de bridage étant disposée entre les axes longitudinaux de chaque paire adjacente desdites ouvertures, et des moyens de fixation (16) destinés à fixer de façon amovible lesdites barrettes (14) de bridage audit panneau (10) afin d'assujettir lesdits connecteurs (40, 42) audit panneau de façon que des parties de bords opposés de la bride de montage (50) de chaque connecteur soient maintenues, respectivement, au moyen de deux barrettes (14) de bridage contre des parties dudit panneau (10) disposées sur des côtés opposés d'une ouverture allongée (12) dudit panneau, une partie quelconque d'une ouverture (12) non recouverte par une bride de montage (50) étant fermée par une plaque (55) d'obturation électriquement conductrice dont des parties de bords opposés sont maintenues respectivement par les deux barrettes de bridage concernées (14) contre des parties dudit panneau (10) disposées sur des côtés opposés de ladite ouverture.

2. Panneau de connecteurs multiples selon la revendication 1, dans lequel chaque barrette de bridage (14) est en matière électriquement conductrice.

3. Panneau de connecteurs multiples selon la revendication 1 ou la revendication 2, dans lequel chacune desdites barrettes de bridage (14) présente une largeur sensiblement égale à l'écartement entre des ouvertures allongées adjacentes (12) dudit panneau (10).

4. Panneau de connecteurs multiples selon l'une quelconque des revendications précédéntes, dans lequel ladite ou chacune desdites plaques d'obturation (55) est constituée d'une feuille de matière ayant une épaisseur inférieure à celle desdites brides (50) et comporte au moins une nervure transversale (58) destinée à augmenter l'épaisseur utile de ladite plaque d'obturation afin qu'elle corresponde à l'épaisseur desdites brides.

5. Assemblage de connecteurs multiples selon l'une quelconque des revendications précédentes, dans lequel au moins certaines desdites brides de montage (50) se présentent chacune sous la forme d'une plaque présentant une ouverture centrale dans laquelle le connecteur respectif est inséré et qui est fixée de manière amovible au connecteur respectif.

6. Assemblage de connecteurs multiples selon l'une quelconque des revendications précédéntes, dans lequel chaque barrette de bridage (14) comporte des parties longitudinales évidées (20) s'étendant le long de ses côtés opposés, chaque partie évidée (20) étant destinée à recevoir une partie d'un bord d'une bride (50) de montage en maintenant la bride contre le panneau (10).

## FIG. I

## FIG. 2

1

# FIG. 3

10

14

# FIG. 4

14

19

20

# FIG. 5

# FIG. 6